# FASCICULE DE BREVET EUROPEEN

(11) **EP 1 065 767 B1**
(45) Date de publication et mention de la délivrance du brevet: **30.03.2005**
(21) Numéro de dépôt: 00401846.1
(22) Date de dépôt: 28.06.2000
(51) Int. Cl.: H01S 5/14

(54) **Source laser avec filtrage intégré de l'émission spontanée amplifiée**
Laserquelle mit integrierter Filterung der verstärkten spontanen Emission
Laser source with integrated filtering of the Amplified Spontaneous Emission

(30) Priorité: 30.06.1999 FR 9908398
(43) Date de publication de la demande: 03.01.2001
(73) Titulaire: NETTEST PHOTONICS, 78340 Les Clayes Sous Bois (FR)
(72) Inventeur: Lefevre, Hervé, 75014 Paris (FR); Graindorge, Philippe, 21800 Chevigny Saint Sauveur (FR)
(74) Mandataire: Michelet, Alain

(56) Documents cités:
- EP-A- 0 702 438
- EP-A- 0 718 936
- EP-A- 0 917 261
- CLAPS R ET AL: "RAMAN SPECTROSCOPY WITH A SINGLE-FREQUENCY, HIGH-POWER, BROAD-AREA LASER DIODE" APPLIED SPECTROSCOPY,US,THE SOCIETY FOR APPLIED SPECTROSCOPY. BALTIMORE, vol. 53, no. 5, mai 1999 (1999-05), pages 491-496, XP000827272 ISSN: 0003-7028

## Description

La présente invention concerne une source laser équipée d'un système dispersif rétroréfléchissant dans la configuration de Littman-Metcalf.

On sait que des dispositifs dispersifs rétroréfléchissants sont avantageusement utilisés pour constituer l'un des systèmes rétroréfléchissants d'une cavité laser résonnante, de manière à sélectionner spectralement l'une ou certaines des raies susceptibles d'être produites par la cavité.

On connaît par exemple le brevet français FR-2.595.013 qui décrit une source laser monomode de ce type. La longueur d'onde d'émission est sélectionnée dans le spectre large d'un guide d'onde amplificateur avec une cavité externe comportant un système dispersif rétroréfléchissant comprenant un réseau de diffraction. Dans le cas particulier de cette source de l'art antérieur, un mouvement changeant l'orientation angulaire du dispositif dispersif permet de faire varier la longueur d'onde sélectionnée et émise par la source laser.

Ces sources laser mettent en oeuvre un ensemble dispersif rétroréflecteur dans la configuration dite de Littman-Metcalf où le faisceau collimaté incident fait un angle θ₁ avec la normale au réseau. Un réflecteur additionnel est placé avec sa normale ayant un angle θ₂ sur le réseau et la longueur d'onde λ qui respecte la condition λ = p (sin θ₁+ sin θ₂) où p est le pas du réseau, est dispersée par le réseau à un angle θ₂ puis rétroréfléchie sur le réflecteur qui lui est alors perpendiculaire. Enfin, elle est dispersée de nouveau dans le réseau au retour et ressort sous l'angle θ₁ d'entrée. La longueur d'onde λ est donc ainsi sélectionnée par la cavité. Il est possible de faire varier cette longueur d'onde λ en faisant varier l'orientation de l'ensemble réseau-réflecteur, c'est-à-dire en faisant varier θ₁ ou bien en faisant varier uniquement l'orientation du réflecteur, c'est-à-dire en faisant varier θ₂ ou enfin en faisant varier uniquement l'orientation du réseau, c'est-à-dire en faisant varier θ₁, et θ₂ tout en conservant θ₁ - θ₂ constant.

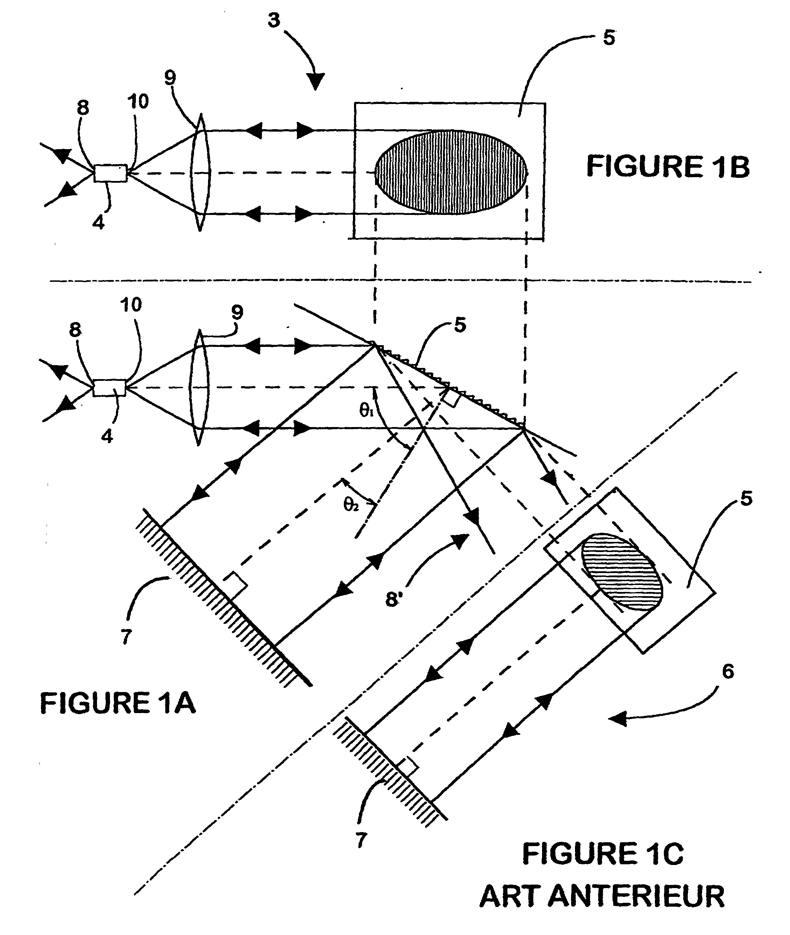

Une telle source laser à cavité externe équipée d'un système dispersif rétroréfléchissant 2 dans la configuration de Littman-Metcalf est représentée sur la figure 1 et peut être présentée comme comportant un premier bras 3 actif contenant un guide amplificateur 4 , par exemple une diode semiconductrice, un réseau de diffraction 5 et un deuxième bras 6 passif et fermé par un réflecteur 7.

La configuration habituelle de ces sources utilise la face externe 8 partiellement réfléchissante de la diode 4 comme porte de sortie du laser et le deuxième bras 6 est alors fermé par un réflecteur 7 total. Ce réflecteur peut être un miroir plan ou bien un dièdre, tel que représenté sur la figure 2, assurant l'auto-alignement à une dimension de la cavité comme décrit dans le brevet français FR-2.595.013. Rappelons que l'on appelle auto-alignement, la propriété d'un système optique pour lequel les propriétés du flux lumineux sortant sont peu sensibles à l'orientation ou à la position du système par rapport au flux entrant. L'auto-alignement peut être réalisé à deux dimensions, c'est-à-dire dans tous les plans parallèles à la direction du faisceau entrant, ou à une seule dimension, c'est-à-dire dans un seul de ces plans, c'est cette dernière propriété qui nous intéresse ici.

Une lentille de collimation 9 formée par un système optique convergent au foyer objet duquel se trouve la face interne 10 du guide d'onde amplificateur 4, rend parallèle le faisceau émergeant de ce guide 4.

Il a aussi été proposé d'utiliser l'ordre zéro du réseau 5 comme porte de sortie 8' avec alors une face externe 8 du guide amplificateur 4 totalement réfléchissante. Dans ces deux cas, la lumière émise provient directement du guide amplificateur et comprend une raie laser de grande finesse spectrale associée à un fond continu large bande résiduel appelé émission spontanée amplifiée ou ASE (pour Amplified Spontaneous Emission). La puissance d'ASE résiduelle peut atteindre plusieurs pourcents de la puissance de la raie, ce qui apporte une limitation dans les applications de spectroscopie par laser accordable. Il faut alors ajouter en sortie un filtre accordé sur la longueur d'onde d'émission, mais la synchronisation de la longueur d'onde du filtre sur la longueur d'onde d'émission de la source est très délicate.

Le but de l'invention est l'amélioration d'une telle source de façon à filtrer directement l'ASE résiduelle du faisceau lumineux de sortie de la cavité sans perte significative de puissance et en évitant l'utilisation d'un filtre accordé additionnel.

A cet effet, l'invention concerne une source laser à cavité externe avec filtrage intégré de l'émission spontanée amplifiée équipée d'un système dispersif rétroréfléchissant dans la configuration de Littman-Metcalf comportant un premier bras actif s'étendant d'un premier réflecteur d'extrémité jusqu'au réseau et contenant un milieu amplificateur qui produit un premier faisceau lumineux, un deuxième bras passif s'étendant du réseau à un deuxième réflecteur d'extrémité, ledit réseau y générant un deuxième faisceau par diffraction du premier,

Selon l'invention, qui est définie dans la revendication 1:
- le réflecteur fermant le deuxième bras passif est partiellement réfléchissant et permet l'extraction d'un flux lumineux et,
- des moyens optiques produisent, à partir du deuxième faisceau, un troisième faisceau translaté et de direction paralléle et de sens de propagation contraire (dit aussi "antiparallèle") qu'ils renvoient sur le réseau qui, par diffraction, forme un quatrième faisceau translaté et de direction paralléle et de sens de propagation contraire (dit aussi " antiparallèle") au premier faisceau.

Dans différents modes de réalisation présentant chacun leurs avantages spécifiques et susceptibles d'être combinés selon de nombreuses configurations techniquement possibles :
- lesdits moyens optiques de filtrage de l'ASE sont placés sur le trajet du faisceau prélevé par le réflecteur partiellement réfléchissant du deuxième bras et le renvoient, après sortie de la cavité, sur le réseau, dans une direction parallèle à celle du deuxième bras ;
- lesdits moyens optiques sont placés dans le deuxième bras de la source qui est replié parallèlement à lui-même, repasse par le réseau et se termine sur le réflecteur partiellement réfléchissant ;
- la source laser comprend un guide d'onde constituant le milieu amplificateur et dont la face externe, entièrement réfléchissante, ferme le premier bras ;
- la source laser est accordable en longueur d'onde par la rotation des moyens réflecteurs du deuxième bras ;
- le réflecteur est un composant optique partiellement réfléchissant produisant, à partir d'un faisceau incident, deux faisceaux secondaires, l'un transmis, l'autre réfléchi, comportant une première face plane entièrement réfléchissante et une deuxième face plane partiellement réfléchissante, la deuxième face étant perpendiculaire à la première, une troisième face plane entièrement réfléchissante, les première et troisième faces étant dans le même plan, ce composant assurant l'auto-alignement à une dimension du faisceau réfléchi avec le faisceau incident, les faisceaux respectivement transmis et réfléchi étant chacun formé de deux demi-faisceaux ayant des fronts d'onde concordants ;
- le composant optique partiellement réfléchissant est tel que la première et la deuxième faces sont les faces d'un même premier prisme, et que la troisième face est portée par un deuxième prisme portant une quatrième face au contact de la deuxième face du premier prisme ; de préférence, ces deux prismes ont le même indice de réfraction ;
- le composant optique partiellement réfléchissant comporte une cinquième face parallèle à la troisième face, le faisceau transmis étant renvoyé parallèlement dans le même sens que le faisceau incident ;
- le composant optique partiellement réfléchissant comporte une cinquième face parallèle à la deuxième face, le faisceau transmis étant renvoyé parallèlement au faisceau incident et en sens opposé ;
- le composant optique partiellement réfléchissant est tel que les premier et deuxième prismes sont fixés l'un à l'autre et forment un bloc unitaire dont les orientations des faces les unes par rapport aux autres sont contrôlées, quel que soit le prisme auquel elles appartiennent ;
- le composant optique partiellement réfléchissant est tel que l'une des deuxième et quatrième faces porte un traitement partiellement réfléchissant.

L'invention sera décrite plus en détail en référence aux dessins annexés où chaque figure est décomposée en vue de dessus et de cotés parallèlement au premier bras et au deuxième bras, respectivement dénommées A, B, C et dans lesquels :
- les figures 1 et 2 sont des représentations de sources laser de l'art antérieur ;
- la figure 3 est une représentation schématique d'un premier mode de réalisation de l'invention ;
- la figure 4 est un cas particulier du premier mode de réalisation de l'invention avec un composant optique assurant la fonction de réflexion partielle auto-alignée ;
- la figure 5 est une représentation d'un deuxième mode de réalisation de l'invention ;
- la figure 6 est un cas particulier du deuxième mode de réalisation de l'invention avec un composant optique assurant la fonction de réflexion partielle auto-alignée.

Sur ces différentes figures, les composants analogues portent les mêmes références.

Le dispositif de l'invention comporte une cavité formée entre la face extérieure 8 d'une diode laser 4 et un dispositif au moins partiellement réflecteur. Cette cavité est formée de deux bras, respectivement 3 et 6, et un réseau 5 placé dans la cavité sélectionne la longueur d'onde d'émission.

On appelle ici, premier bras 3 de la cavité, le chemin optique s'étendant de la face externe 8 du milieu amplificateur, de préférence une diode laser, faisant office de premier réflecteur d'extrémité de la cavité de la source laser, jusqu'au réseau 5. Le chemin optique s'étendant du réseau 5 jusqu'au deuxième réflecteur d'extrémité est qualifié de deuxième bras 6, quelle que soit sa forme. En particulier, dans certains modes de réalisation de l'invention, il comporte lui même un ou plusieurs réflecteurs.

Le faisceau laser 11 filtré de l'ASE par un premier passage sur le réseau 5 est renvoyé une deuxième fois sur celui-ci, ce qui produit un faisceau de sortie 12 de direction constante, parallèle au premier bras 3 de la cavité, quelle que soit la longueur d'onde.

Ainsi, l'anamorphose du faisceau produite par son premier passage sur le réseau 5 est compensée au deuxième passage. De plus, la réjection de l'ASE est améliorée par le deuxième passage sur le réseau.

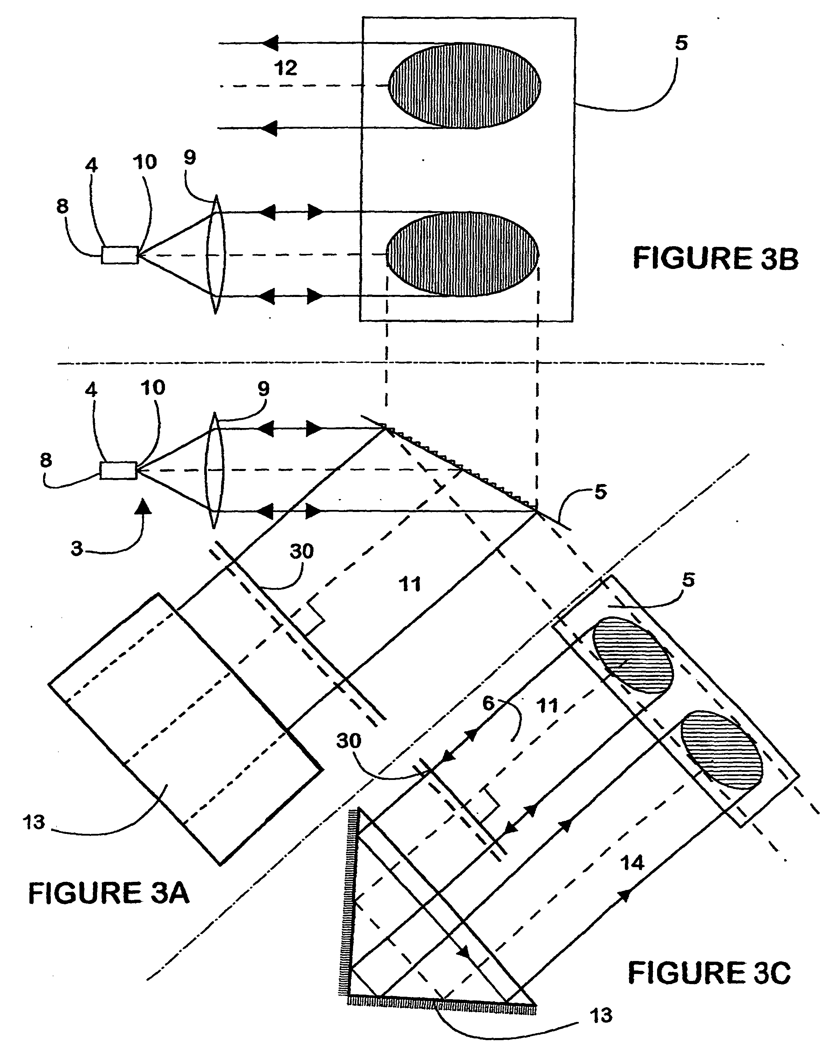

Dans un premier mode de réalisation présenté sur la figure 3, ce renvoi du faisceau sur le réseau de diffraction 5 est réalisé après l'extraction du flux lumineux de la cavité laser. La lame partiellement transparente 30, qui constitue le deuxième réflecteur de la cavité laser externe renvoie une partie du faisceau 11 dans la cavité et en prélève une partie pour former le faisceau sortant. Le faisceau sortant est alors dirigé par le composant optique 13 sur le réseau 5 dans une direction translatée parallèle au deuxième bras 6 de la cavité laser. Le composant 13 est, de préférence, un dièdre assurant l'auto-alignement à une dimension du faisceau émergeant par rapport au faisceau incident. Le flux sortant est reçu par le réseau sous l'angle correspondant à sa longueur d'onde et permettant sa diffraction dans une direction parallèle au premier bras 3 de la cavité.

Cette diffraction du flux sortant par le réseau permet d'assurer un filtrage de l'ASE, une compensation de l'anamorphose préalablement causée par ce même réseau et un maintien de la direction du flux émergent, y compris quelque soit la longueur d'onde, lorsque la cavité est du type à longueur d'onde variable.

Plusieurs mises en oeuvre de ce premier mode de réalisation de l'invention sont possibles.

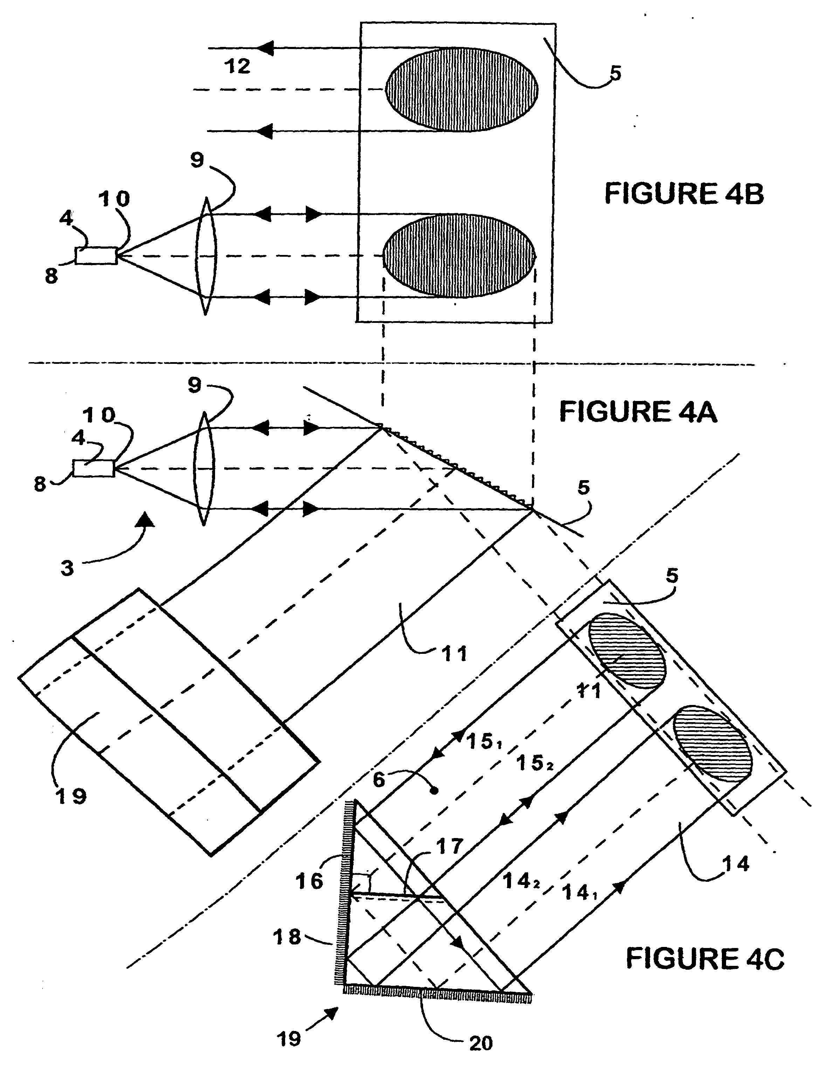

La figure 4 représente un mode de réalisation préféré d'un tel dispositif utilisant un composant optique 19 qui comporte une première face plane 16 entièrement réfléchissante, une deuxième face plane 17 partiellement réfléchissante et perpendiculaire à la première face plane 16.

Il comporte également une troisième face plane 18 entièrement réfléchissante, contenue dans le même plan que la première face plane 16.

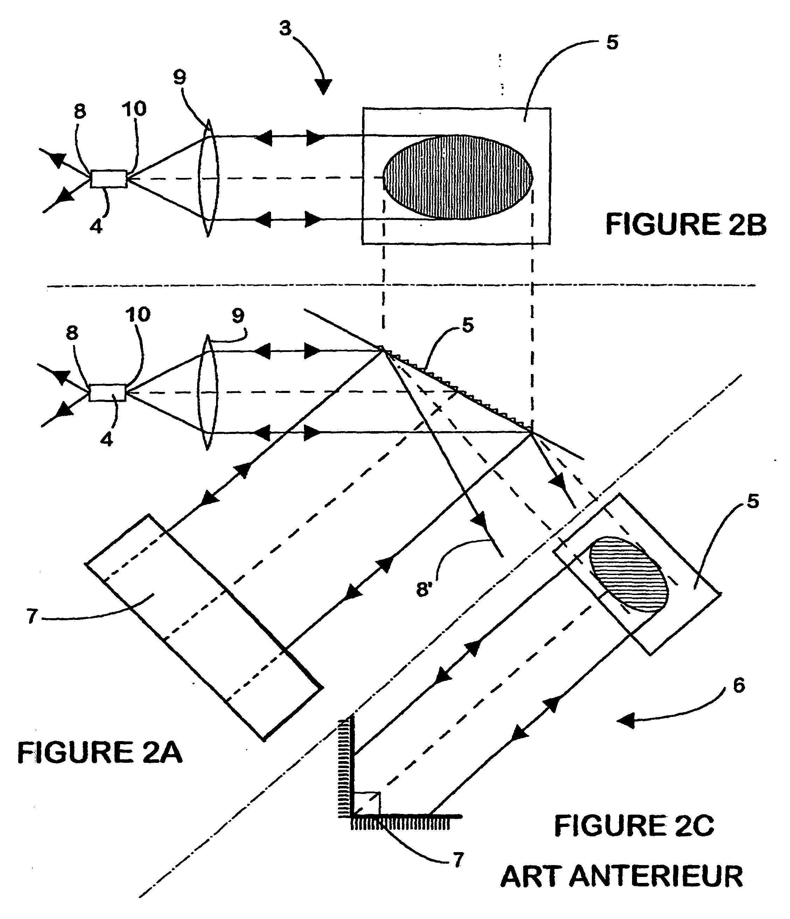

Ainsi, le faisceau rétroréfléchi 15 est formé à partir du faisceau incident 11 par deux réflexions successives, respectivement sur les deux faces perpendiculaires 16 et 17. Il est connu, et cela a été décrit en référence à la figure 2 que, dans de telles conditions, l'angle formé par le faisceau 15 avec le faisceau incident 11 est égal à 180° étant le double de l'angle formé par les deux faces 16 et 17, c'est-à-dire que ce faisceau incident 11 est renvoyé parallèlement et dans la direction opposée au faisceau lui-même.

Le faisceau 14 est lui formé par réflexion sur les première 16 et troisième 18 faces qui sont coplanaires. Le composant 19 comporte une cinquième face 20 sur laquelle le faisceau émergent 14 est réfléchi une nouvelle fois. Cette face 20 étant parallèle à la deuxième face 17 du composant optique, la direction du faisceau émergent 14 est parallèle et de sens inverse à celle du faisceau incident 11.

Le composant optique 19 remplit ainsi les deux fonctions qui lui sont assignées, c'est-à-dire la production à partir d'un faisceau incident 11, d'une part d'un faisceau réfléchi auto-aligné à une dimension 15 et, d'autre part d'un faisceau transmis 14, renvoyé sur le réseau dans une direction parallèle au faisceau incident.

Le rapport d'énergie entre le faisceau 11 et le faisceau 14 dépend du taux de réflexion de la face partiellement réfléchissante 17.

Avantageusement, les première et deuxième faces 16 et 17 sont les faces d'un premier prisme et la troisième face 18 est portée par un autre prisme qui a une quatrième face au contact de la deuxième face 17 du premier prisme et une cinquième face 20.

Les deux faisceaux émergents 14 et 15 produits par ce composant sont formés de deux demi-faisceaux, chacun en phase avec l'autre, c'est-à-dire que pour le faisceau rétroréfléchi 15, les fronts d'onde des deux demi-faisceaux 15₁ et 15₂ sont concordants. Il en est de même pour les demi-faisceaux 14₁ et 14₂ formant le faisceau extrait 14. Autrement dit, le faisceau d'entrée 11 est découpé par ce composant, les deux demi-faisceaux 15₁ et 15₂ formant respectivement les demi-faisceaux rétroréfléchis et les demi-faisceaux extraits 14₁ et 14₂. Les demi-faisceaux 15₁ et 15₂ d'une part, 14₁ et 14₂ d'autre part, sont en phase, leurs fronts d'onde sont concordants, ce qui permet à chacun d'eux de se recoupler efficacement dans une fibre monomode ou un guide d'onde monomode.

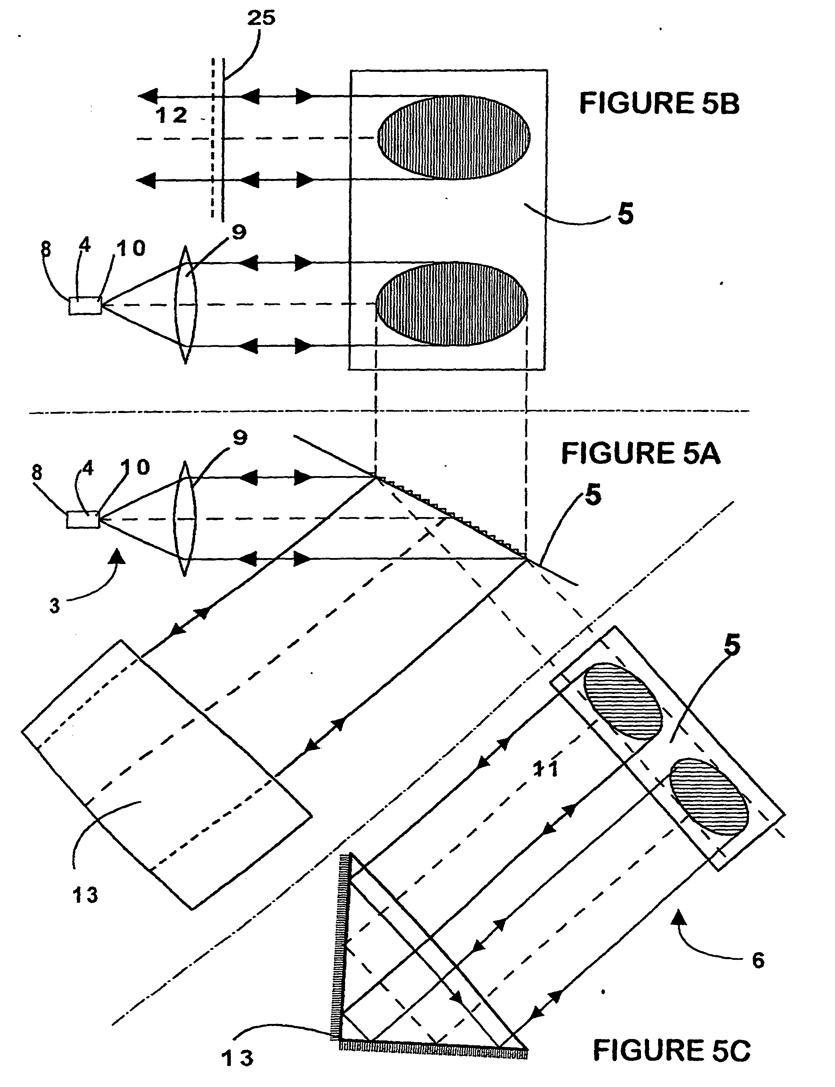

Dans un deuxième mode de réalisation décrit sur la figure 5, le flux lumineux amplifié 11 est renvoyé une deuxième fois sur le réseau avant son extraction de la cavité. Un réflecteur total auto-aligné 13 est alors placé sur le deuxième bras 6 de la cavité et renvoie le flux lumineux amplifié dans la direction parallèle et de sens opposé à celle du faisceau incident 11. Ainsi, l'angle d'incidence du faisceau sur le réseau 5, lors de son deuxième passage, est le même que celui du premier passage.

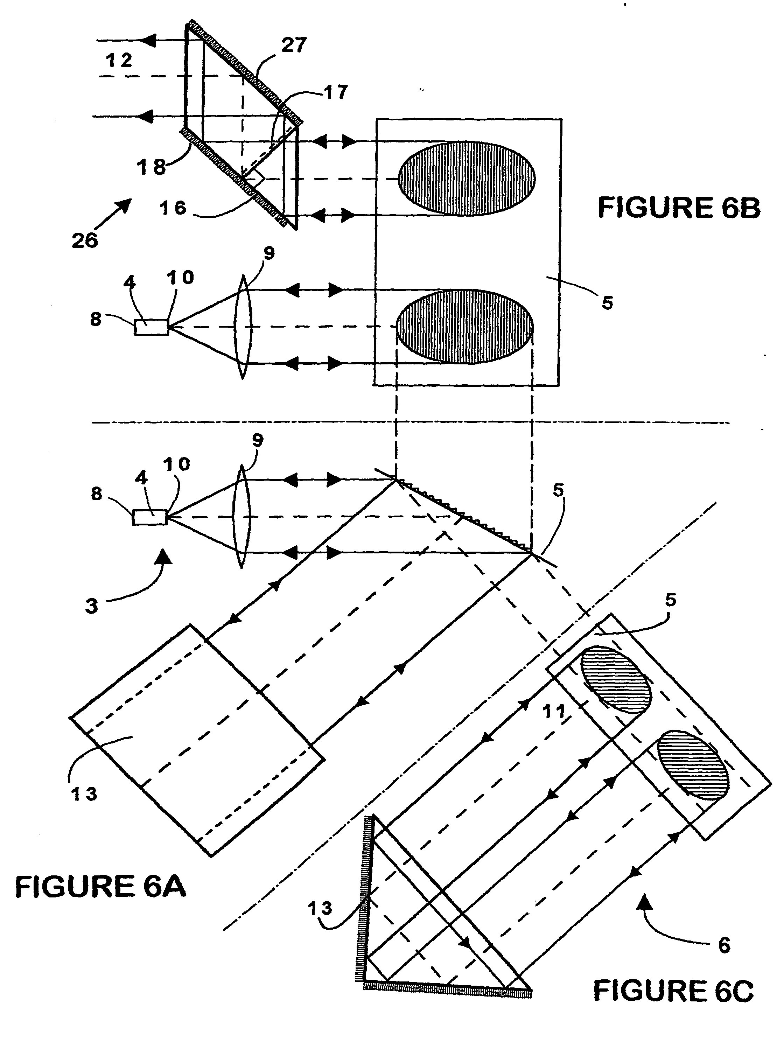

L'extraction du flux lumineux est alors réalisée par un composant partiellement réfléchissant constitué, soit par une lame partiellement réfléchissante 25, soit comme dans le mode de réalisation préférentiel présenté en figure 6, par un composant optique 26 partiellement réfléchissant auto-aligné similaire à celui déjà décrit plus haut qui assure à la fois la fonction de rétroréflexion auto-alignée à une dimension et l'extraction d'une partie du faisceau. Dans ce mode de réalisation, ce composant 26 a avantageusement ses faces entièrement réfléchissantes 16, 18 et 27 parallèles, le flux de sortie ayant ainsi la même direction que le flux incident.

## Revendications

1. Source laser à cavité externe avec filtrage intégré de l'émission spontanée amplifiée équipée d'un système dispersif rétroréfléchissant (5, 30) dans la configuration de Littman-Metcalf comportant un premier bras (3) actif s'étendant d'un premier réflecteur d'extrémité (8) jusqu'au réseau (5) et contenant un milieu amplificateur (4) qui produit un premier faisceau lumineux, un deuxième bras (6) passif s'étendant du réseau (5) à un deuxième réflecteur d'extrémité, ledit réseau (5) y générant un deuxième faisceau par diffraction du premier,
**caractérisée en ce que** :
- le réflecteur (30) fermant le deuxième bras passif est partiellement réfléchissant et permet l'extraction d'un flux lumineux et,
- des moyens optiques (13), placés sur le trajet du deuxième faisceau, produisent, à partir dudit deuxième faisceau, un troisième faisceau extérieur à la cavité externe, translaté et de direction paralléle et de sens de propagation contraire, qu'ils renvoient sur le réseau qui, par diffraction, forme un quatrième faisceau translaté et de direction paralléle et de sens de propagation contraire au premier faisceau.

2. Source laser selon la revendication 1, **caractérisée en ce que** lesdits moyens optiques (13) sont placés dans le deuxième bras de la source qui est replié parallèlement à lui-même, repasse par le réseau (5) et se termine sur le réflecteur (25) partiellement réfléchissant.

3. Source laser selon la revendication 1 ou 2, **caractérisée en ce qu'**elle comprend un guide d'onde constituant le milieu amplificateur et dont la face interne porte un traitement antiréfléchissant et est placée au foyer d'une lentille de collimation, et dont la face externe, entièrement réfléchissante, ferme le premier bras.

4. Source laser selon l'une quelconque des revendications 1 à 3, **caractérisée en ce qu'**elle est accordable en longueur d'onde.

5. Source laser selon l'une quelconque des revendications 1 à 4, **caractérisée en ce que** le réflecteur partiellement réfléchissant produisant, à partir d'un faisceau incident, deux faisceaux secondaires, l'un transmis, l'autre réfléchi, comporte :
- une première face plane entièrement réfléchissante,
- une deuxième face plane partiellement réfléchissante, la deuxième face étant perpendiculaire à la première,
- une troisième face plane entièrement réfléchissante,
les première et troisième faces étant dans le même plan,
ce composant assurant l'auto-alignement à une dimension du faisceau réfléchi avec le faisceau incident, les faisceaux respectivement transmis et réfléchi étant chacun formé de deux demi-faisceaux ayant des fronts d'onde confondus.

6. Source laser selon la revendication 5, **caractérisée en ce que** le réflecteur partiellement réfléchissant est tel que la première et la deuxième faces sont les faces d'un même premier prisme, et que la troisième face est portée par un deuxième prisme portant une quatrième face au contact de la deuxième face du premier prisme.

7. Source laser selon la revendication 6, **caractérisée en ce que** le réflecteur partiellement réfléchissant comporte une cinquième face parallèle à la troisième face, le faisceau transmis étant renvoyé parallèlement dans le même sens que le faisceau incident.

8. Source laser selon la revendication 6, **caractérisée en ce que** le réflecteur partiellement réfléchissant comporte une cinquième face parallèle à la deuxième face, le faisceau transmis étant renvoyé parallèlement au faisceau incident et en sens opposé.

9. Source laser selon la revendication 6 ou 8, **caractérisée en ce que** le réflecteur partiellement réfléchissant est tel que les premier et deuxième prismes sont fixés l'un à l'autre et forment un bloc unitaire dont les orientations des faces les unes par rapport aux autres sont contrôlées, quel que soit le prisme auquel elles appartiennent.

10. Source laser selon l'une quelconque des revendications 6 à 9, **caractérisée en ce que** le réflecteur partiellement réfléchissant est tel que l'une des deuxième et quatrième faces porte un traitement partiellement réfléchissant.

## Patentansprüche

1. Laserquelle mit externem Hohlraumresonator, mit integrierter Filterung der verstärkten spontanen Emission, ausgerüstet mit einer retroreflektierenden Streuvorrichtung (5, 30) in einem Littman-Metcalf-System, beinhaltend einen ersten aktiven Arm (3), der sich von einem ersten Endpunktreflektor (8) bis zum Diffraktionsraster (5) erstreckt und welcher ein Verstärkungsmittel (4) enthält, das einen ersten Lichtstrahl erzeugt, einen zweiten passiven Arm (6), der sich von dem Diffraktionsraster (5) bis zu einem zweiten Endpunktreflektor erstreckt, wobei das genannte Raster (5) dort einen zweiten Lichtstrahl durch Diffraktion des ersten Lichtstrahls generiert,
**dadurch gekennzeichnet,**
**dass**:
- der Reflektor (30), der den zweiten passiven Arm abschließt, teilreflektierend ist und die Extraktion eines Lichtflusses ermöglicht, und
- optische Mittel (13), welche auf der Bahn des zweiten Strahles angeordnet sind, ausgehend von dem genannten zweiten Lichtstrahl einen dritten Lichtstrahl ausserhalb des externen Hohlraumresonators verschoben parallel und in entgegengesetzter Ausbreitungsrichtung erzeugen, den sie auf das Raster lenken, das durch Diffraktion einen vierten Lichtstrahl verschoben parallel und in entgegengesetzter Ausbreitungsrichtung zum ersten Lichtstrahl bildet.

2. Laserquelle nach Anspruch 1,
**dadurch gekennzeichnet,**
**dass** die genannten optischen Mittel (13) in dem zweiten Arm der Quelle angeordnet sind, der parallel zu sich selbst zurückgebogen ist, wieder durch das Raster (5) geht und am teilreflektierenden Reflektor (25) endet.

3. Laserquelle nach Anspruch 1 oder 2,
**dadurch gekennzeichnet,**
**dass** sie einen Wellenleiter umfasst, der das Verstärkermittel bildet, und dessen Innenseite eine antireflektierende Schicht aufweist und der in dem Brennpunkt einer Kollimierlinse angeordnet ist und dessen totalreflektierende Außenseite den ersten Arm abschließt.

4. Laserquelle nach einem der Ansprüche 1 bis 3,
**dadurch gekennzeichnet,**
**dass** sie in der Wellenlänge abstimmbar ist.

5. Laserquelle nach einem der Ansprüche 1 bis 4,
**dadurch gekennzeichnet,**
**dass** der teilreflektierende Reflektor, der ausgehend von einem Eingangsstrahl zwei sekundäre Strahlen erzeugt, einer durchgelassen und der andere reflektiert,
- eine erste totalreflektierende ebene Fläche,
- eine zweite teilreflektierende ebene Fläche, wobei die zweite Fläche senkrecht zu der ersten ist,
- eine dritte totalreflektierende ebene Fläche enthält,
wobei sich die erste und die dritte Fläche in der gleichen Ebene befinden, wobei diese Anordnung die eindimensionale Selbstausrichtung des reflektierten Strahles zu dem einfallenden Strahl gewährleistet, wobei der durchgelassene bzw. der reflektierte Strahl jeweils aus zwei Halb-Strahlen mit vereinigten Wellenfronten gebildet sind.

6. Laserquelle nach Anspruch 5,
**dadurch gekennzeichnet,**
**dass** der teilreflektierende Reflektor derart ausgebildet ist, dass die erste und die zweite Fläche Seiten des gleichen Prismas sind und dass die dritte Seite von einem zweiten Prisma getragen wird, welches eine vierte Seite an der Berührungsstelle der zweiten Seite des ersten Prismas trägt.

7. Laserquelle nach Anspruch 6,
**dadurch gekennzeichnet,**
**dass** der teilreflektierende Reflektor eine fünfte Seite parallel zu der dritten Seite aufweist, wobei der durchgelassene Strahl parallel in der gleichen Richtung wie der Eingangsstrahl abgegeben wird.

8. Laserquelle nach Anspruch 6,
**dadurch gekennzeichnet,**
**dass** der teilreflektierende Reflektor eine fünfte Seite parallel zu der zweiten Seite aufweist, wobei der durchgelassene Strahl parallel und in der entgegengesetzten Richtung zu dem Eingangsstrahl abgegeben wird.

9. Laserquelle nach Anspruch 6 oder 8,
**dadurch gekennzeichnet,**
**dass** der teilreflektierende Reflektor derart ausgebildet ist, dass das erste und das zweite Prisma aneinander befestigt sind und diese einen einheitlichen Block bilden, wobei die Orientierungen einiger Seiten gegenüber den anderen kontrolliert sind, unabhängig von dem Prisma, zu dem sie gehören.

10. Laserquelle nach einem der Ansprüche 6 bis 9,
**dadurch gekennzeichnet,**
**dass** der teilreflektierende Reflektor derart ausgebildet ist, dass entweder die zweite oder die vierte Seite eine teilreflektierende Beschichtung aufweist.

## Claims

1. An external cavity laser source with integral filtering of the amplified spontaneous emission provided with a retroreflecting dispersing system (5, 30) in the Littman-Metcalf configuration comprising a first active arm (3) extending from a first end reflector (8) up to the grating (5) and having an amplifier medium (4) that produces a first luminous beam, whereas a second passive arm (6) extends from the grating (5) to a second end reflector, whereas the said grating (5) generates a second beam by diffraction of the first beam,
**characterised in that**:
- the reflector (30) closing the second passive arm is partially reflecting and enables extraction of a luminous flux and,
- optical means (13) located on the second beam path produce, from said second beam, a third beam external to the external cavity translated and of parallel direction and opposite propagation direction that they return to the grating which, by diffraction, forms a fourth beam translated and of parallel direction and opposite propagation direction to the first beam.

2. A laser source according to claim 1, **characterised in that** the said optical means (13) are located in the second arm of the source that is folded parallel to itself, goes through the grating (5) again and ends on the partially reflecting reflector (25).

3. A laser source according to claim 1 or 2, **characterised in that** it comprises a wave-guide forming the amplifier medium and whose internal face has an antireflecting coating and is located at the focus of a collimation lens, and whose external face, entirely reflecting, closes the first arm.

4. A laser source according to any one of claims 1 to 3, **characterised in that** it is wavelength tuneable.

5. A laser source according to any one of claims 1 to 4, **characterised in that** the partially reflecting reflector producing, from an incident beam, two secondary beams, one transmitted, the other reflected, comprises:
- a first plane face that is entirely reflecting,
- and a second plane face that is partially reflecting, whereas the second face is perpendicular to the first,
- a third plane face that is entirely reflecting,
whereby the first and third faces are situated on the same plane,
whereas this component ensures one-dimension self-alignment of the reflected beam with the incident beam, whereby the beams respectively transmitted and reflected are each composed of two semi-beams with matching wave fronts.

6. A laser source according to claim 5, **characterised in that** the partially reflecting reflector is such that the first and the second faces are the faces of the same first prism, and that the third face is carried by a second prism carrying a fourth face in contact with the second face of the first prism.

7. A laser source according to claim 6, **characterised in that** the partially reflecting reflector comprises a fifth face parallel to the third face, whereas the transmitted beam is sent back parallel in the same direction as the incident beam.

8. A laser source according to claim 6, **characterised in that** the partially reflecting reflector comprises a fifth face parallel to the second face, whereas the transmitted beam is sent back parallel to the incident beam and in reverse direction.

9. A laser source according to claims 6 or 8, **characterised in that** the partially reflecting reflector is such that the first and second prisms are fixed to one another and form an integral block whereby the orientations of their faces with respect to one another are controlled, regardless of the prism to which they belong;

10. A laser source according to any one of claims 6 to 9, **characterised in that** the partially reflecting reflector is such that one of the second and fourth faces exhibits a partially reflecting treatment.
